# EUROPEAN PATENT APPLICATION

(11) **EP 4 823 256 A1**
(43) Date of publication of application: **14.10.2026**
(21) Application number: 24948856.0
(22) Date of filing: 25.07.2024
(51) Int. Cl.: H05K 7/20, H01Q 1/02, H04B 1/3822

(54) **TELEMATICS MODULE AND CONTROL METHOD THEREFOR**

(71) Applicant: LG Electronics Inc., Yeongdeungpo-gu Seoul 07336 (KR)
(72) Inventor: JUNG, Wonmoog, Seoul 06772 (KR); LEE, Heonjong, Seoul 06772 (KR)
(74) Representative: Vossius & Partner Patentanwälte Rechtsanwälte mbB
(86) International application number: PCT/KR2024/010856
(87) International publication number: WO 2026/023726

(57) **Abstract**

The telematics module installed in a vehicle comprises: a PCB disposed in a space between an upper cover and a protruding surface of a lower cover; a NAD module disposed in a first region, which corresponds to the protruding surface, of the PCB, the NAD module having a modem, a memory, and an RF transmission/reception unit; and a heat dissipation module which is disposed between the NAD module and the protruding surface, and transfers, by operating in accordance with a driving voltage, heat generated in the NAD module to the protruding surface and a frame.

## Description

### Technical Field

The present disclosure relates to a telematics module and a method of controlling the telematics module. More particularly, the present disclosure relates to a telematics module, including a plurality of communication modules and a heat dissipation structure, and a method of controlling the telematics module.

### Background Art

Recently, there has been an increasing need to provide communication services through a vehicle. A telematics module is arranged within the vehicle to provide the communication services to the vehicle. Enhancing the performance of a vehicular telematics module requires high performance and high-level integration of a communication module used therein.

The high performance and high-level integration of the communication module in the vehicular telematics module result in an increase in the levels of heat generated by components. When the telematics module, mounted in the vehicle, operates, it reaches an elevated temperature. In addition, the telematics module mounted in the vehicle may be exposed to an environment with high external temperatures. This increase in temperature significantly affects the performance reliability of the communication module and components used within the telematics module.

In a case where a fan is used to dissipate heat generated by the components, an occupant in the vehicle may be disturbed by the operational noise of the fan, depending on the mounting position of the fan within the vehicle. In addition, when the fan is mounted in an electric vehicle, the operational noise of the fan may be perceived as more prominent.

Therefore, the use of a fanless thermoelectric (TEC) in the communication module and the components of the telematics module removes the operational noise of the fan, thereby ensuring the lifespans, operations, and temperature reliabilities of the communication module and the components. In this regard, there is a need to provide a method of controlling heat dissipation in a heat dissipation mode that varies according to the temperatures of the electronic components arranged in the electronic component.

### Disclosure of Invention

### Technical Problem

The objects of the present disclosure are to address the above-mentioned problems and other related problems. One object of the present disclosure is to provide an antenna module, including a plurality of communication modules and a heat dissipation structure, in a vehicle.

Another object of the present disclosure is to implement an optimal heat dissipation structure by considering a layout structure of electronic components arranged on different substrates.

A further object of the present disclosure is to provide a method of controlling heat dissipation in a heat dissipation mode that varies according to the temperatures of electronic components arranged on a substrate.

Another object of the present disclosure is to provide a method of controlling heat dissipation in a heat dissipation mode that varies according to an operating mode in a vehicle.

Still another object of the present disclosure is to ensure the lifespans, operations, and temperature reliabilities of modules and components through optimal heat dissipation according to each operating condition of a telematics module.

### Solution to Problem

To accomplish the above-mentioned or other related objects, there is provided a telematics module for mounting in a vehicle, the telematics module including: a PCB arranged in a space between a protrusion surface of a lower cover and an upper cover; an NAD module, arranged in a first region of the PCB, the first region corresponding to the protrusion surface, that includes a modem, a memory, and an RF transceiver; and a heat dissipation module, arranged between the NAD module and the protrusion surface, that operates according to a driving voltage and transfers heat generated in the NAD module to the protrusion surface and the frame.

According to an embodiment, there is provided a telematics module for mounting in a vehicle, the telematics module including: a lower cover that includes at least one protrusion surface protruding in the shape of an enclosure from a bottom surface coupled to a frame of the vehicle, the frame being formed of a metal material; an upper cover coupled to the lower cover; a PCB arranged in a space between the protrusion surface of the lower cover and the upper cover; an NAD module, arranged in a first region of the PCB, the first region corresponding to the protrusion surface, that includes a modem, a memory, and an RF transceiver; and a heat dissipation module, arranged between the NAD module and the protrusion surface, that operates according to a driving voltage and transfers heat generated in the NAD module to the protrusion surface and the frame. In the telematics module, the NAD module assigns a priority to each communication mode and variably controls the driving voltage of the heat dissipation module according to the priority.

According to an embodiment, in the telematics module, the protrusion surface may include a first protrusion surface corresponding to a first region of the PCB and a second protrusion surface corresponding to a second region of the PCB. The telematics module may further include: a V2X module arranged in the second region of the PCB, the second region corresponding to the second protrusion surface. In the telematics module, the NAD module may be arranged in the first region of the PCB, the first region corresponding to the first protrusion surface.

According to an embodiment, in the telematics module, a plurality of integrated circuits, including the memory and the RF transceiver of the NAD module and an electronic component of the V2X module, may be configured to have different reference temperatures for driving a TEC.

According to an embodiment, in the telematics module, in a case where the plurality of integrated circuits are driven simultaneously, the NAD module may drive the heat dissipation module based on an integrated circuit having a low reference temperature for heat dissipation, among the plurality of integrated circuits.

According to an embodiment, in the telematics module, the NAD module may drive the heat dissipation module at a first voltage value in response to a booting signal and may drive the heat dissipation module by a change to a second voltage value different from the first voltage value in response to a call order.

According to an embodiment, in the telematics module, in a case where a call is connected at the second voltage value in response to the call order, the NAD module may drive the heat dissipation module by a change to a third voltage value lower than the second voltage value.

According to an embodiment, in the telematics module, the heat dissipation module may include: a first heat dissipation module arranged in a first sub-region of the NAD module in which the modem and the memory adjacent to the modem are arranged, and a second heat dissipation module arranged in a second sub-region of the NAD module in which the RF transceiver is arranged. In the telematics module, when the temperature of heat generated in the NAD module is equal to or higher than a first threshold temperature, the NAD module may control the first heat dissipation module and the second heat dissipation module in such a manner that the first heat dissipation module and the second heat dissipation module are driven simultaneously, and, when the temperature of the heat generated in the NAD module is lower than a second threshold temperature, the NAD module may control the first heat dissipation module and the second heat dissipation module in such a manner that the first heat dissipation module is driven and that the second heat dissipation module is not driven.

### Advantageous Effects of Invention

The technical effects of an antenna module mounted in a vehicle and the technical effects of the vehicle are described as follows.

According to the present disclosure, the antenna module, including a plurality of communication modules and a heat dissipation structure, can be provided in a vehicle.

According to the present disclosure, a priority is assigned to each communication mode, and a voltage for driving the heat dissipation structure is variably controlled according to the priority. To perform these functions, the antenna module, including the plurality of communication modules, and the heat dissipation structure, can be provided in the vehicle.

According to the present disclosure, an optimal heat dissipation structure and a method of controlling heat dissipation can be implemented by considering a layout structure of electronic components arranged on different substrates corresponding to protrusion surfaces, respectively, of a lower cover.

According to the present disclosure, a method of controlling heat dissipation in a variable heat dissipation mode can be provided by driving a heat dissipation module at a driving voltage that varies according to the temperatures of electronic components arranged on a substrate.

According to the present disclosure, a method of controlling heat dissipation in a variable heat dissipation mode can be provided by driving the heat dissipation module at a driving voltage that varies according to different operating modes in the vehicle.

According to the present disclosure, a driving algorithm for the heat dissipation structure is changed according to each operating situation by applying the heat dissipation structure to a communication module and components within a telematics module. This change can achieve optimal heat dissipation, thereby ensuring the lifespans, operations, and temperature reliabilities of modules and components.

A further range of applications of the present disclosure will become apparent from the following detailed description. However, it will be apparent to a person of ordinary skill in the art that various alterations and modifications to the present disclosure may be readily made without departing from the legal and technical breadth of the technical idea of the present disclosure. The detailed descriptions of specific embodiments, such as preferred embodiments of the disclosure, should be understood as illustrative examples only.

### Brief Description of Drawings

FIG. 1 is a view illustrating a vehicle according to an embodiment of the present disclosure.
FIGS. 2A and 2B are views illustrating a structure of the vehicle according to the present disclosure that is configured to include an antenna module, the structure in which the antenna module is mountable within the vehicle.
FIG. 3 is a view illustrating a configuration of the vehicle according to the embodiment of the present disclosure.
FIG. 4 is a cross-sectional view illustrating a telematics module mounted in the vehicle according to the embodiment of the present description.
FIG. 5 is a cross-sectional view illustrating the telematics module mounted in a vehicle according to another embodiment of the present disclosure.
FIG. 6 is a view illustrating the structure of the lower cover in FIG. 4 or 5.
FIG. 7 is a set of views illustrating a structure in which electronic components are arranged in an NAD module and a V2X module in FIGS. 4 and 5.
FIG. 8 is a set of views illustrating a structure and an implementation example of a heat dissipation module according to the present description.
FIG. 9 is a flowchart illustrating a method of controlling the telematics module that enters a booting mode.
FIG. 10 is a flowchart illustrating the method of controlling the telematics module, entering the booting module, in such a manner as to operate in one of a plurality of operating modes.
FIGS. 11 to 13 are flowcharts illustrating methods of controlling the telematics module according to first to third operating modes, respectively.
FIG. 14 is a flowchart illustrating a method of controlling the driving of the heat dissipation module based on a temperature difference at both ends of the heat dissipation module.
FIG. 15 is a flowchart illustrating a method of controlling the driving of the heat dissipation module based on the driving time of the heat dissipation module.

### Mode for the Invention

Embodiments disclosed in the present specification will be described in detail below with reference to the accompanying drawings. The same reference numerals are used for the same or similar constituent elements, regardless of figure numbers, and redundant descriptions thereof are not repeated. The terms 'module' and 'unit' are hereinafter used interchangeably to name constituent elements solely for the convenience of description in the present specification. These terms are not intended to have different meanings or to indicate different functions. In addition, in describing the embodiments disclosed in the present specification, detailed descriptions of well-known related technologies may be omitted when such descriptions are deemed to obscure the nature and gist of the present disclosure. In addition, the accompanying drawings are provided solely to aid understanding of the embodiment that is disclosed in the present specification, and the technical idea that is disclosed in the present specification is not limited to the accompanying drawings. All amendments, equivalents, and substitutions that fall within the scope of the technical idea behind the present disclosure are intended to be encompassed by the accompanying drawings.

The ordinal numbers first, second, and so forth may be used to describe various elements, but they do not limit these elements. These terms are used merely to distinguish among constituent elements having similar functions.

It should be understood that a constituent element, when referred to as 'being connected to' or 'having access to' a different constituent element, may be directly connected to or have direct access to the different constituent element, or may be indirectly connected to or have access to the different constituent element through one or more intermediate constituent elements. Likewise, it should be understood that, when a constituent element is described as being 'connected to' or 'having access to' another constituent element, such connection or access may be direct without the need for one or more intermediary constituent elements.

A noun in singular form, unless clearly indicated otherwise by the context, shall be understood to include the plural form. The terms 'include,' 'have,' or equivalents thereof, as used in the present disclosure, are intended to indicate the presence of described stated features, numbers, steps, operations, constituent elements, components, or combinations thereof, without precluding the presence or addition of one or more other features, numbers, steps, operations, constituent elements, components, or combinations thereof.

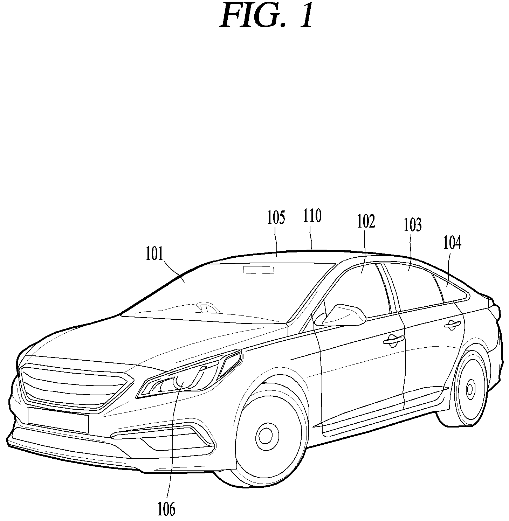

An antenna module according to the present disclosure will be described in detail. In this regard, FIG. 1 is a view illustrating a vehicle according to an embodiment of the present disclosure.

With reference to FIG. 1, a vehicle 1 may include at least one communication antenna. The vehicle 1 may transmit and/or receive signals in various frequency bands using the communication antenna. The vehicle 1 can perform communications for Vehicle-to-Vehicle (V2V), Vehicle-to-Infrastructure (V2I), Vehicle-to-Pedestrian (V2P), and Vehicle-to-Network (V2N).

The antenna may be configured with a substrate formed of polyethylene terephthalate (PET) and an antenna pattern formed on the substrate. For example, the antenna may be a transparent antenna.

The antenna may be arranged a glass pane of the vehicle 1. The antenna may be coupled to or attached to a front windshield 101, door glass panes 102 and 103, a quarter glass pane 104, a rear windshield (not illustrated), a side-view mirror (not illustrated), a sunroof 105, or a lamp glass pane 106. For example, the antenna may be a transparent antenna. As another example, the antenna may be arranged in a region in which a roof 110 of the vehicle 1 is formed.

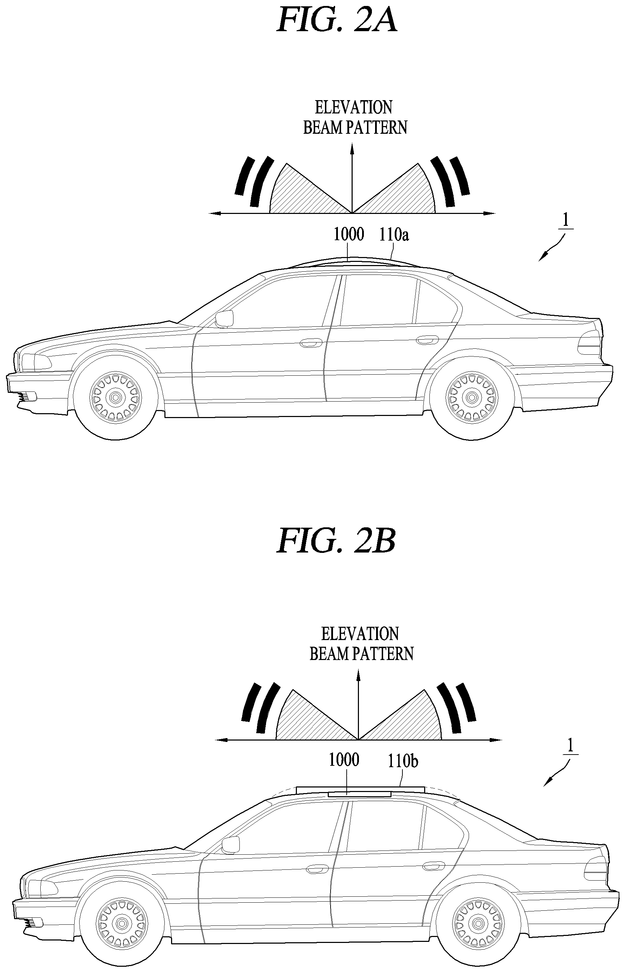

FIGS. 2A and 2B are views illustrating a structure of the vehicle according to the present disclosure that is configured to include an antenna module, the structure in which the antenna module is mountable within the vehicle.

With reference to FIGS. 2A and 2B, according to the present disclosure, an existing shark pin antenna is replaced with a non-protruding flat antenna to improve the exterior appearance of an automobile (vehicle) and to maintain telematics performance in the event of a collision. In addition, according to the present disclosure, not only is an existing mobile communication service (LTE) provided, but an antenna into which an LTE antenna for 5G communication and a 5G antenna are integrated is also provided.

With reference to FIG. 2A, an antenna module 1000 is positioned on the roof of the vehicle 1. In FIG. 2A, a radome 110a for protecting the antenna module 1000 from external impacts under external environmental conditions and during vehicle driving may surround an antenna system 1000. The radome 110a may be formed of a dielectric material through which radio wave signals transmitted to or received from the antenna system 1000 and from an infrastructure, such as a base station, or another vehicle, can pass.

With reference to FIG. 2B, the antenna module 1000 may be arranged within a roof structure of the vehicle 1 and may be configured in such a manner that at least one portion of the roof structure is formed of a non-metallic material. In this case, at least one portion of the roof structure 110b of the vehicle may be formed of a non-metal material, but the other portions thereof may be formed of a dielectric material through which radio wave signals transmitted to or received from the antenna system 1000 and from an infrastructure, such as a base station, or another vehicle, can pass.

With reference to FIGS. 2A and 2B, a region in which a beam pattern is formed by an antenna provided in the antenna module 1000 mounted in the vehicle may need to be oriented at a predetermined angle extending a horizontal region toward an elevation direction.

In this regard, the peak of an elevation beam pattern of the antenna provided in the antenna module 1000 does not need to be formed at the boresight. Accordingly, the peak of the elevation beam pattern of the antenna needs to be formed at a predetermined angle from the horizontal plane toward an elevation direction. For example, the elevation beam pattern of the antenna may be formed in the shape of a hemisphere, as illustrated in FIGS. 2A and 2B. In addition, a beam peak is formed within a range of low elevation angles (e.g., at 30 degrees or less), and thus the elevation beam pattern of the antenna may be referred to as a low elevation beam pattern.

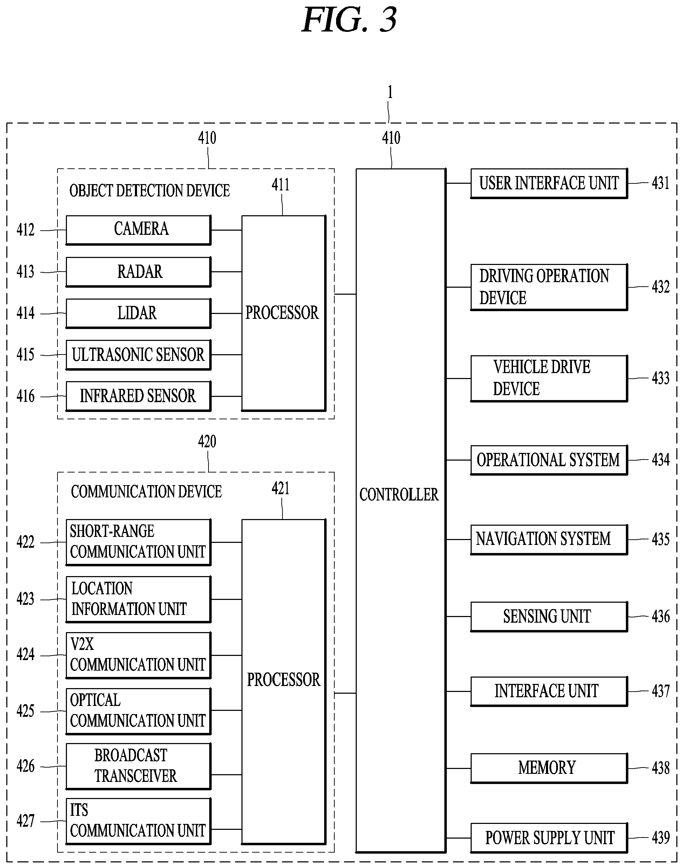

FIG. 3 is a view illustrating a configuration of the vehicle according to the embodiment of the present disclosure. With reference to FIG. 3, the vehicle 1 may include an object detection device 410, a communication device 420, a user interface device 431, a driving operation device 432, a vehicle drive device 433, an operational system 434, a navigation system 435, a sensing unit 436, an interface unit 437, a memory 438, a power supply unit 439, and/or a control unit 440. The vehicle 1 may further include one or more constituent elements other than the above-mentioned constituent elements or may omit one or more of the above-mentioned constituent elements.

The object detection device 410 may be a device for detecting an object located outside the vehicle 1. For example, the object detection device 410 may include a processor 411, a camera 412, a radar 413, a LiDAR 414, an ultrasonic sensor 415, and/or an infrared sensor 416.

The communication device 420 may be a device for performing communication with an external device. The communication device 420 may include at least one of the following: a transmission antenna, a reception antenna, a radio frequency circuit, or an RF element. The transmission antenna and the reception antenna are used to perform communication. The radio frequency circuit and the RF element are capable of executing various communication protocols. For example, the communication device 420 may include a processor 421, a short-range communication unit 422, a position information unit 423, a V2X communication unit 424, an optical communication unit 425, a broadcast transceiver 426, and/or an ITS communication unit 427.

The user interface device 431 may be a device for enabling interaction between the vehicle 1 and a user. The vehicle 1 may implement a user interface (UI) or a user experience (UX) through the user interface device 431.

The driving operation device 432 may be a device that receives a user input for driving. The vehicle drive device 433 may be a device that electrically controls the driving of various devices within the vehicle 1. The operational system 434 may be a system that controls various operations of the vehicle 1. The navigation system 435 may provide navigation information. The sensing unit 436 may sense a state of the vehicle 1.

The interface unit 437 may function as an interface for various types of external devices that are connected to the vehicle 1. The memory 438 may store basic data regarding units of the vehicle 1, control data for operational control of the units, input and output data, and the like. The power supply unit 439 may provide the electric power necessary to operate the constituent elements. The controller 440 may control the overall operation of each unit within a vehicle 1. The controller 440 may be implemented as an electronic control unit (ECU) and/or a telematics control unit (TCU).

With reference to FIGS. 1 to 3, the antenna system mounted in the vehicle may be positioned within the vehicle, on the roof of the vehicle, within the roof, or within a roof frame. In this regard, the antenna system disclosed in the present specification may be configured to operate in a low band (LB), a mid band (MB), and a high band (HB) for a 4G LTE system, and in a Sub-6 band for a 5G NR system.

A telematics module mounted in the vehicle according to the present disclosure and a method of controlling the telematics module. One object of the present disclosure is to provide an antenna module, including a plurality of communication modules and a heat dissipation structure, in the vehicle. Another object of the present disclosure is to implement an optimal heat dissipation structure by considering a layout structure of electronic components arranged on different substrates. A further object of the present disclosure is to provide a method of controlling heat dissipation in a heat dissipation mode that varies according to the temperatures of electronic components arranged on a substrate. Another object of the present disclosure is to provide a method of controlling heat dissipation in a heat dissipation mode that varies according to an operating mode in a vehicle. Still another object of the present disclosure is to ensure the lifespans, operations, and temperature reliabilities of modules and components through optimal heat dissipation according to each operating condition of a telematics module.

All electronic components are arranged on respective first and second surfaces of substrates arranged within the vehicular antenna module, and the substrates may occupy a reduced volume. Specifically, a network access device (NAD) substrate on which electronic components for 5G wireless communication are arranged may be a double-sided board. The NAD substrate, configured as a double-sided substrate, may be formed to have a double-sided heat dissipation structure. The size-reduced NAD substrate may be arranged in an optimal layout on a main PCB.

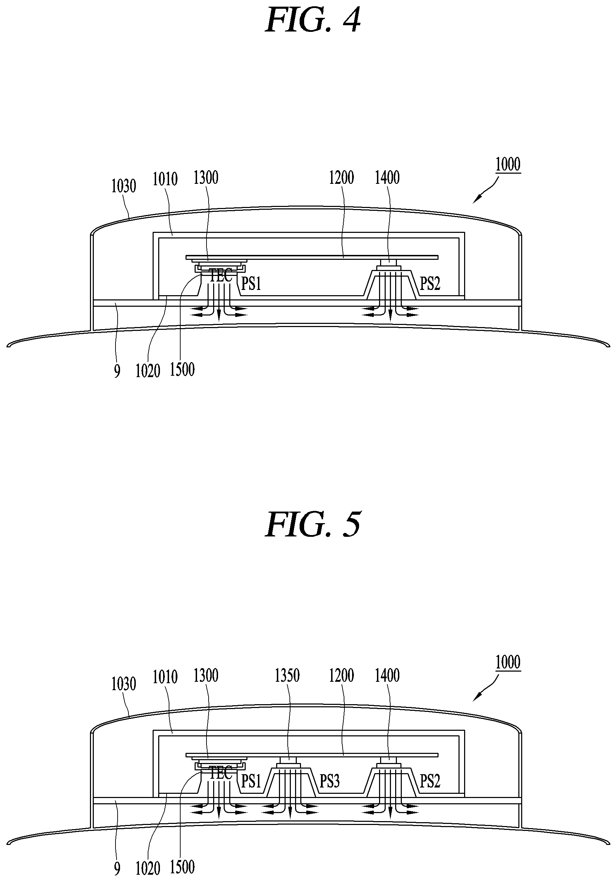

FIG. 4 is a cross-sectional view illustrating the telematics module mounted in the vehicle according to the embodiment of the present disclosure. With reference to FIG. 4, an NAD module 1300 may be arranged in a first region of a PCB 1200, the first region corresponding to a first protrusion surface PS1. The NAD module 1300 may be arranged between the first protrusion surface PS1 and a heat dissipation module 1500. A V2X module 1400 may be arranged in a second region of the PCB 1200, the second region corresponding to a second protrusion surface PS2.

FIG. 5 is a cross-sectional view illustrating the telematics module mounted in a vehicle according to another embodiment of the present specification. With reference to FIG. 5, an NAD module 1300 may be arranged in a first region of a PCB 1200, the first region corresponding to a first protrusion surface PS1. The NAD module 1300 may be arranged between the first protrusion surface PS1 and a heat dissipation module 1500. A V2X module 1400 may be arranged in the second region of the PCB 1200, the second region corresponding to a second protrusion surface PS2. A processor 1350 may be arranged in a third region of the PCB 1200, the third region corresponding to a third protrusion surface PS3.

With reference to FIGS. 4 and 5, a telematics module 1000 mounted in the vehicle according to the present disclosure is described. The telematics module 1000 may be arranged between a frame 9 of the vehicle, the frame being formed of a metal material, and a roof cover 1030 formed of a non-metal material. Electronic components of the telematics module 1000 may be arranged in a space between a lower cover 1010 and an upper cover 1020.

The telematics module 1000 may be configured to have a fanless heat dissipation structure under high-temperature external air conditions. Accordingly, the telematics module 1000 may control the operation of a thermoelectric cooler TEC without a fan under high-temperature external air conditions. A method of controlling the operation of the TEC varies according to each operating mode, that is, a call mode. An operating algorithm may vary according to an external air temperature, a temperature of a component, a temperature difference between the hot side and cold side of the TEC, a TEC operation time, a TEC driving voltage, and an electric current.

The heat dissipation structure, including the heat dissipation module 1500, may be configured to include the TEC and a heat sink. The heat dissipation structure may include a heat sink, a heat spreader, or the like as an external structure. According to the present disclosure, the lower cover 1010 may be formed to have a structure in which the heat sink is mounted thereto. The TEC mounted in the telematics module 1000 is enabled to operate the moment electric power (ignition) is applied to the vehicle and does not operate when electric power is removed from the vehicle. The telematics module mounted in the vehicle according to the present disclosure may vary in installation position depending on the vehicle. The telematics module, mounted in the vehicle according to the present disclosure, and the method of controlling the telematics module include a preliminary algorithm for abnormal operation in the call mode when the TEC is driven unexpectedly.

The telematics module 1000 may be configured to include the lower cover 1010, the upper cover 1020, the PCB 1200, the NAD module 1300, the V2X module 1400, and the heat dissipation module 1500. The telematics module 1000 of FIG. 5 may be configured to further include the processor 1350. The processor 1350 may be configured as a microcontroller unit (MCU) that controls the operation of the vehicle. The lower cover 1010 and the upper cover 1020 may be referred to as a first cover and a second cover, respectively. The NAD module 1300 and the V2X module 1400 may be configured as PCBs. The NAD module 1300 and the V2X module 1400 may be referred to as a first PCB and a second PCB, respectively.

The lower cover 1010 may be formed to have a heat sink structure in such a manner that heat generated within the telematics module 1000 can be dissipated to the outside through the frame 9 formed of a metal material. The lower cover 1010 may include a bottom surface coupled to the frame 9 of the vehicle, the frame being formed of a metal material, and at least one protrusion surface that protrudes in the shape of an enclosure from the bottom surface. The shape of an enclosure refers to a region surrounded by a wall or a fence in such a manner that a substrate including electronic components is arranged therein. At least one protrusion surface may be referred to as a first protrusion surface PS1.

At least one protrusion surface may be configured to include the first protrusion surface PS1 and the second protrusion surface PS2. The lower cover 1010 may be configured to include a bottom surface coupled to the frame 9 of the vehicle, the frame 9 being formed of a metal material, the first protrusion surface PS1 and the second protrusion surface PS2 that protrude from the bottom surface, and a third protrusion surface PS3 between the first protrusion surface PS1 and the second protrusion PS2.

Since the heat generated in the NAD module 1300 exceeds the heat generated in other modules, the first protrusion surface PS1 may be formed to have an internal metal structure. The first protrusion surface PS1 may be integrally formed with the lower cover 1020 formed of a metal material. The second protrusion surface PS2 and the third protrusion surface PS3 may be formed to have a hollow structure. The second protrusion surface PS2 may be formed to have a structure in which one end and the other end thereof are connected to the lower cover 1020. The third protrusion surface PS3 may be formed to have a structure in which one end and the other end thereof are connected to the lower cover 1020.

The first protrusion surface PS1, the second protrusion surface PS2, and the third protrusion surface PS3 of the lower cover 1020 may be configured as coating regions formed of a thermally conductive material to dissipate the heat generated from electronic components to the frame 9 formed of a metal material and outward from the frame 9. To improve heat dissipation performance, the TEC may be applied to the heat dissipation module 1500. In addition, front surfaces of the protrusion surfaces of the lower cover 1020, the front surfaces being in contact with electronic components, may be configured as coating regions formed of a material capable of absorbing heat. The front surfaces of the protrusion surfaces of the lower cover 1020 may be formed of a black coating material capable of absorbing heat. The front surfaces of the protrusion surfaces of the lower cover 1020 may be configured as coated regions formed of a material having a threshold emissivity of, for example, 0.8 or more.

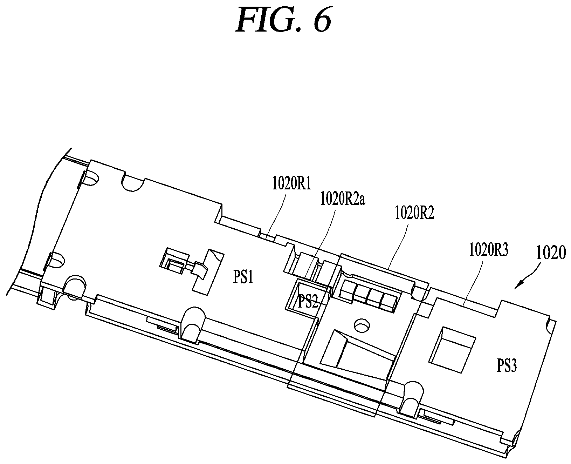

FIG. 6 is a view illustrating the structure of the lower cover in FIG. 4 or 5. With reference to FIGS. 4 to 6, the heat dissipation module 1500 may be arranged between the NAD module 1300 and the first protrusion surface PS1 of the lower cover 1020. The first protrusion surface PS1 may be formed in a first region 1020R1 of the lower cover 1020, and the heat dissipation module 1500 may be arranged to contact the first protrusion surface PS1.

The application of the heat dissipation module 1500 transfers the heat generated in the heat dissipation module 1500 to an MCU and V2X components. To minimize this transfer, a second region 1020R2 of the lower cover 1020 may be formed to have a second thickness smaller than a first thickness of the first region 1020R1. The second region 1020R2 of the lower cover 1020 may be referred to as a thickness-reduced region. The reduction in the thickness of the second region 1020R2 of the lower cover 1020 may minimize the transfer of the heat generated in the heat dissipation module 1500 to the surroundings and may reduce the weight of a product.

The second protrusion surface PS2 may be formed in the thickness-reduced region of the lower cover 1020. The second protrusion surface PS2 may be formed in the second region of the lower cover 1020. The second protrusion surface PS2 may be formed in a sub-region 1020R2a of the second region of the lower cover 1020. A processor 1350, such as an MCU, may be arranged on the second protrusion surface PS2.

A third region 1030R3 of the lower cover 1020 may be formed to have a third thickness greater than the second thickness of the second region 1020R2 of the lower cover 1020. The third thickness of the third region 1030R3 of the lower cover 1020 may be formed to have a thickness equal to the first thickness of the first region 1020R1 of the lower cover 1020. The third protrusion surface PS3 may be formed on the third region 1030R3 of the lower cover 1020. The processor 1350, such as an MCU, may be arranged on the third protrusion surface PS3.

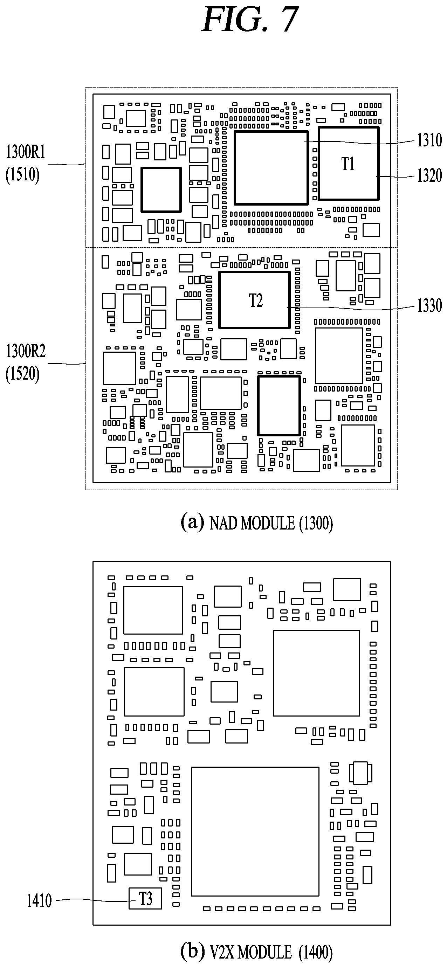

FIG. 7 is a set of views illustrating a structure in which electronic components are arranged in the NAD module and the V2X module in FIGS. 4 and 5. (a) of FIG. 7 illustrates a second surface, which is a rear surface of the NAD module 1300 in FIGS. 4 and 5. A first surface, which is a front surface of the NAD module 1300, may be arranged to face a second surface, which is a rear surface of the PCB 1200. (b) of FIG. 7 illustrates a second surface, which is a rear surface of the V2X module 1400 in FIGS. 4 and 5. A first surface, which is a front surface of the V2X module 1400, may be arranged to face a second surface, which is the rear surface of the PCB 1200.

With reference to FIGS. 4 to 7, the telematics module 1000 according to the present disclosure will be described below. The telematics module 1000 may be configured to include the lower cover 1010, the upper cover 1020, the.PCB 1200, the NAD module 1300, the V2X module 1400, and the heat dissipation module 1500. The upper cover 1020 may be coupled to the lower cover 1010. The upper cover 1020 may be formed of a non-metal material in such a manner as to transmit a wireless signal emitted by an antenna arranged within the upper cover 1020.

The PCB 1200 may be arranged in a space between the first protrusion surface PS1 of the lower cover 1010 and the upper cover 1020. The PCB 1200 may be arranged in a space between the first and second protrusion surfaces PS1 and PS2 of the lower cover 1010 and the upper cover 1020. The PCB 1200 may be arranged in a space between the protrusion surfaces PS1, PS2, and PS3 of the lower cover 1010 and the upper cover 1020.

The NAD module 1300 may be placed in the first region of the PCB 1200 corresponding to the first protrusion surface PS1. The NAD module 1300 may include a modem 1310, a memory 1320, and an RF transceiver 1330 on one surface. The memory 1320 may be configured as a multi-chip package low-power double data rate (MCP LPDDR) memory, but without being limited thereto, may vary according to the application.

The modem 1310, the memory 1320, and the RF transceiver 1330 may be arranged on a lower surface of the NAD module 1300. The heat generated in the modem 1310, the memory 1320, and the RF transceiver 1330, which are arranged on the lower surface of the NAD module 1300, may be cooled through the heat dissipation module 1500 and subsequently transferred to the lower cover 1020 and the frame 9.

The heat generated in the modem 1310 may be transferred to the memory 1320. A first temperature sensor may be arranged in a region adjacent to a region in which the memory 1320 is arranged, in such a manner as to measure a first temperature T1 of the memory 1320. The first temperature sensor may be arranged between the modem 1310 and the memory 1320. A second temperature sensor may be arranged in a region adjacent to a region in which the RF transceiver 1330 is arranged, in such a manner as to measure a second temperature T2 of the RF transceiver 1330.

The V2X module 1400 may be arranged in the second region of the PCB 1200 corresponding to the second protrusion surface PS2. A third temperature sensor may be arranged in a region adjacent to a region in which an electronic component 1410 is arranged, in such a manner as to measure a third temperature T3 of the electronic component 1410 of the V2X module 1400. The processor 1350 may be arranged in the third region of the PCB 1200, the third region corresponding to the third protrusion surface PS3. The third region of the PCB 1200 may be a region between the first region and the second region of the PCB 1200.

Therefore, at least one protrusion surface may include the first protrusion surface PS1, corresponding to the first region of the PCB 1200, and the second protrusion surface PS2, corresponding to the second region of the PCB 1200. In this regard, the NAD module 1300 may be arranged in the first region of the PCB, the first region corresponding to the first protrusion surface PS1. The V2X module 1400 may be arranged in the second region of the PCB 1200, the second region corresponding to the second protrusion surface PS2.

The heat dissipation module 1500 may be arranged between the NAD module 1300 and the first region of the PCB 1200, corresponding to the first protrusion surface PS1 of the PCB 1200. The heat dissipation module 1500 may be configured to operate according to a driving voltage and to transfer the heat generated in the NAD module 1300 to the first protrusion surface PS1 and the frame 9 of the vehicle, the frame 9 being formed of a metal material. The heat dissipation module 1500 may be configured as a thermoelectric cooler (TEC).

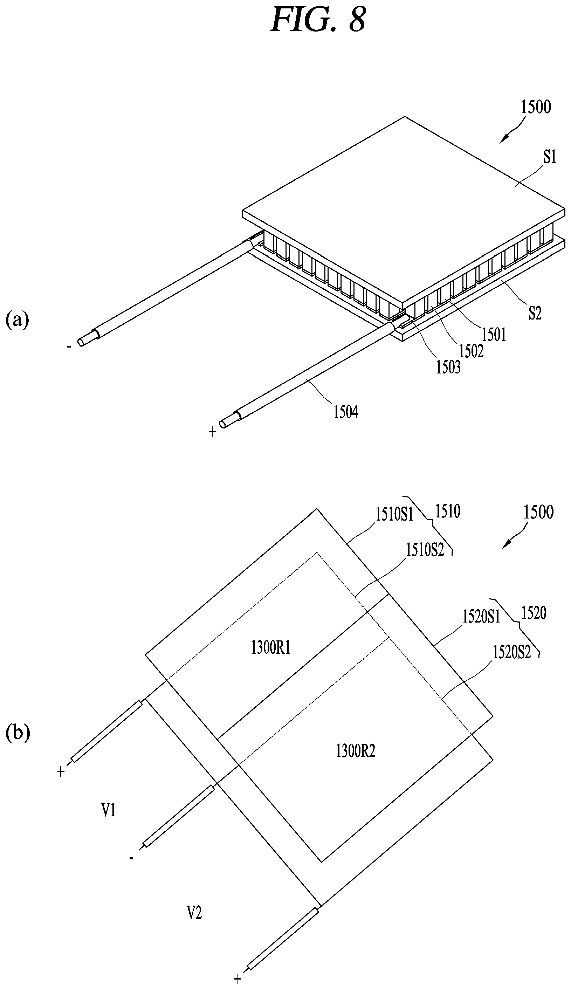

In this regard, FIG. 8 is a set of views illustrating a structure and an implementation example of the heat dissipation module according to the present description. With reference to (a) of FIG. 8, a first surface S1 and a second surface S2 of the heat dissipation module 1500 may be configured as a cool side and a hot side, respectively. The heat dissipation module 1500 may include a p-type semiconductor pellet 1501 formed between the first surface S1 and the second surface S2, an n-type semiconductor pellet 1502, and a conducting tab 1503 formed on the second surface S2. A lead wire 1504 is connected to the conducting tab 1503, and thus a driving voltage may be applied to the heat dissipation module 1500.

With reference to (b) of FIG. 8, the heat dissipation module 1500 may be configured to selectively cool the heat generated in one portion or all portions of the NAD module 1300. To this end, the heat dissipation module 1500 may be configured to include a first heat dissipation module 1510 and a second heat dissipation module 1520. The first heat dissipation module 1510 may include a first surface 1510S1 and a second surface 1510S2, which are configured as the cool side and the hot side, respectively. The second heat dissipation module 1520 may include a first surface 152S1 and a second surface 152S2, which are configured as the cool side and the hot side, respectively. A first driving voltage V1 may be applied to the first heat dissipation module 1510 for operation in a first heat dissipation mode. A second driving voltage V2 may be applied to the second heat dissipation module 152 for operation in a second heat dissipation mode.

With reference to FIGS. 4 to 8, the first heat dissipation module 1510 may be arranged in a first sub-region 1300R1 of the NAD module 1300 in which the modem 1310 and the memory 1320 adjacent to the modem 1310 are arranged. The second heat dissipation module 1520 may be arranged in a second sub-region 1300R2 of the NAD module 1300 in which the RF transceiver 330 is arranged.

When the temperature of the heat generated in the NAD module 1300 is equal to or higher than a first threshold temperature, the NAD module 1300 may control the first heat dissipation module 1510 and the second heat dissipation module 1520 in such a manner that the first heat dissipation module 1510 and the second heat dissipation module 1520 are driven simultaneously. When the temperature of the heat generated in the NAD module 1300 is lower than a second threshold temperature that is lower than the first threshold temperature, the NAD module 1300 may control the first heat dissipation module 1510 and the second heat dissipation module 1520 in such a manner that the first heat dissipation module 1510 is driven and that the second heat dissipation module 1520 is not driven.

It may be determined whether to operate the second heat dissipation module 1520, depending on whether the electric power that is output from the RF transceiver 1330 is equal to or higher than a threshold value, and thus a second temperature of the RF transceiver 1330 is equal to or higher than a threshold temperature. When the second temperature of the RF transceiver 1330 is equal to or higher than the first threshold temperature, the NAD module 1300 may control the first heat dissipation module 1510 and the second heat dissipation module 1520 in such a manner that the first heat dissipation module 1510 and the second heat dissipation module 1520 are driven simultaneously. When the second temperature of the RF transceiver 1330 is lower than the second threshold temperature, which is lower than the first threshold temperature, the NAD module 1300 may control the first heat dissipation module 1510 and the second heat dissipation module 1520 in such a manner that the first heat dissipation module 1510 is driven and that the second heat dissipation module 1520 is not driven.

The NAD module 1300 may be configured to control a driving voltage applied to the heat dissipation module 1500. The modem 1310 of the NAD module 1300 may be configured to control the driving voltage applied to the heat dissipation module 1500. The NAD module 1300 may be configured to assign a priority to each communication mode and to variably control the driving voltage of the heat dissipation module 1500 according to the priority.

A plurality of components and integrated circuits of the PCB 1200 are configured to have different reference temperatures for driving the TEC. The plurality of integrated circuits, including the memory 1320 and the RF transceiver 1330 of the NAD module and the electronic component 1410 of the V2X module 1400, may be configured to have different reference temperatures for driving the TEC.

In a case where the plurality of integrated circuits are driven simultaneously, the NAD module 1300 may control the heat dissipation module 1500 based on an integrated circuit having a low reference temperature for heat dissipation, among the plurality of integrated circuits, in such a manner that the heat dissipation module 1500 is driven.

The NAD module 1300 may control the heat dissipation module 1500 at a first voltage value in response to a booting signal in such a manner that the heat dissipation module 1500 is driven. The NAD module 1300 may control the heat dissipation module 1500 by a change to a second voltage value different from the first voltage value in response to a call order in such a manner that the heat dissipation module 1500 is driven. In a case where a call is connected at the second voltage value in response to the call order, the NAD module 1300 may control the heat dissipation module 1500 by a change to a third voltage value lower than the second voltage value in such a manner that the heat dissipation module 1500 is driven. In this regard, a first voltage value and a corresponding first current value may be 10V and 1.3A, respectively, but without being limited thereto, may be modified according to the application. A second voltage value and a second current value may be 7V and 1.0A, respectively, but are not limited to these values and may be modified according to the application.

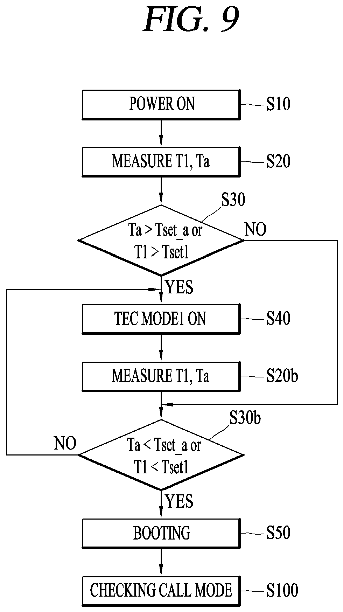

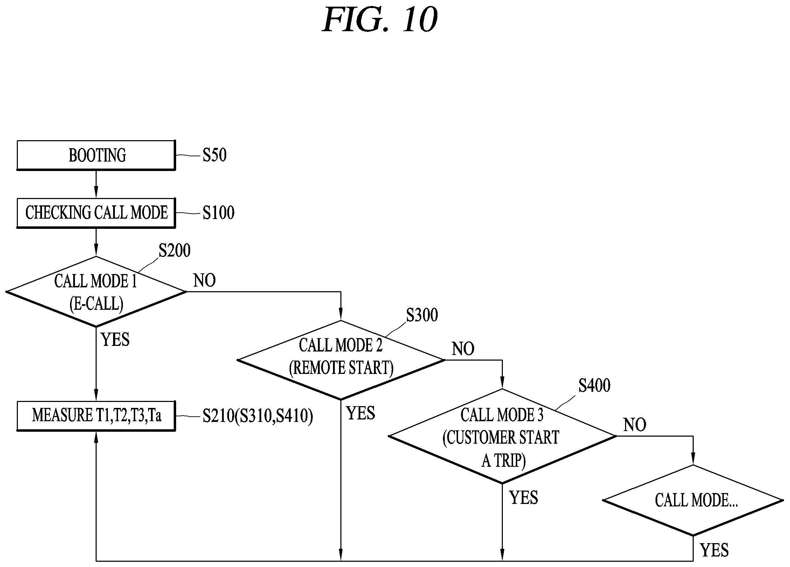

The telematics module mounted in the vehicle according to the present disclosure may be configured to measure an internal temperature and a first temperature of the memory and to operate in one of a plurality of operating modes in a booting mode. In this regard, FIG. 9 is a flowchart illustrating a method of controlling the telematics module that enters the booting mode. FIG. 10 is a flowchart illustrating a method of controlling the telematics module, entering the booting module, in such a manner as to operate in one of a plurality of operating modes.

With reference to FIGS. 4 to 10, a control method that is performed by the NAD module 1300 of the telematics module mounted in the vehicle according to the present disclosure, and the telematics module 1000, performing the control method, are described in detail. The NAD module 1300 may determine a heat dissipation mode based on an internal temperature Ta of the telematics module 1300. In this manner, electric power may be applied to the NAD module 1300 (S10), and the NAD module 1300 may measure the first temperature T1 of the memory 1320 and the internal temperature Ta (S20). In addition, the NAD module 1300 may determine whether the internal temperature Ta or the first temperature T1 of the memory 1320 is equal to or higher than a first threshold temperature Tset_a or Tset1 (S30).

When the internal temperature Ta is higher than the first threshold temperature Tset_a, the NAD module 1300 may control the heat dissipation module 1500 in such a manner to operate in the first heat dissipation mode in which the heat dissipation module operates at a maximum heat dissipation capacity (S40). In addition, when the first temperature T1 of the memory 1320 is higher than the first threshold temperature Tset1, the NAD module 1300 may control the heat dissipation module 1500 in such a manner to operate in the first heat dissipation mode in which the heat dissipation module operates at the maximum heat dissipation capacity (S40). In this regard, the first threshold temperature Tset_a and the first threshold temperature Tset1 may be set to the same temperature, for example, 85 degrees. In the first heat dissipation mode, the first voltage value may be applied to the heat dissipation module 1500. For operation in the first heat dissipation mode, the first voltage value of 10 V is applied to the heat dissipation module 1500, and thus the first current value of 1.3 A may be measured.

When the internal temperature Ta is lower than the first threshold temperature Tset_a, the NAD module 1300 starts a booting mode in which the operation of the telematics module 1300 is initiated (S50). In addition, when the first temperature T1 of the memory 1320 is lower than the first threshold temperature Tset1, the NAD module 1300 starts the booting mode in which the operation of the telematics module 1300 is initiated (S50).

In a case where the internal temperature Ta is higher than the first threshold temperature Tset_a or where the first temperature T1 of the memory 1320 is higher than the first threshold temperature Tset1, a step of control for operation in the first heat dissipation mode is performed (S40). Subsequently, the NAD module 1300 may re-measure the first temperature T1 of the memory 1320 and the internal temperature Ta. Subsequently, it may be determined whether the internal temperature Ta and the first temperature T1 of the memory 1320 are lower than the first threshold temperatures Tset_a and Tset1, respectively.

When the booting mode is entered (S50), the NAD module 1300 may check the operating mode (call mode) (S100) and may execute any one of the plurality of operating modes. In this regard, in response to the booting signal and the operating mode, the NAD module 1300 may control the heat dissipation module 1500 in such a manner as to execute one of the following: a first operating mode, a second operating mode, or a third operating mode, among the plurality of operating modes. The first operating mode may be an emergency call mode, the second operating mode may be a remote start mode, and the third operating mode may be a trip mode.

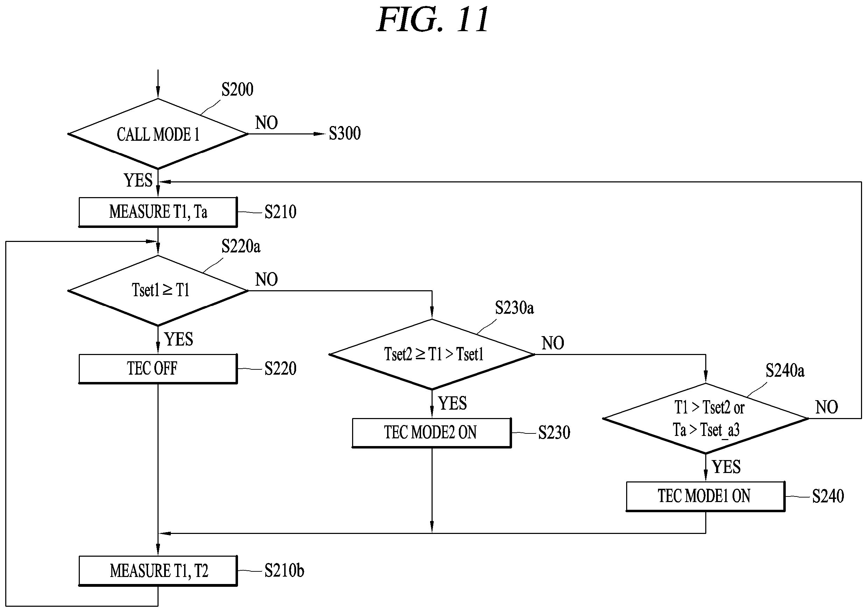

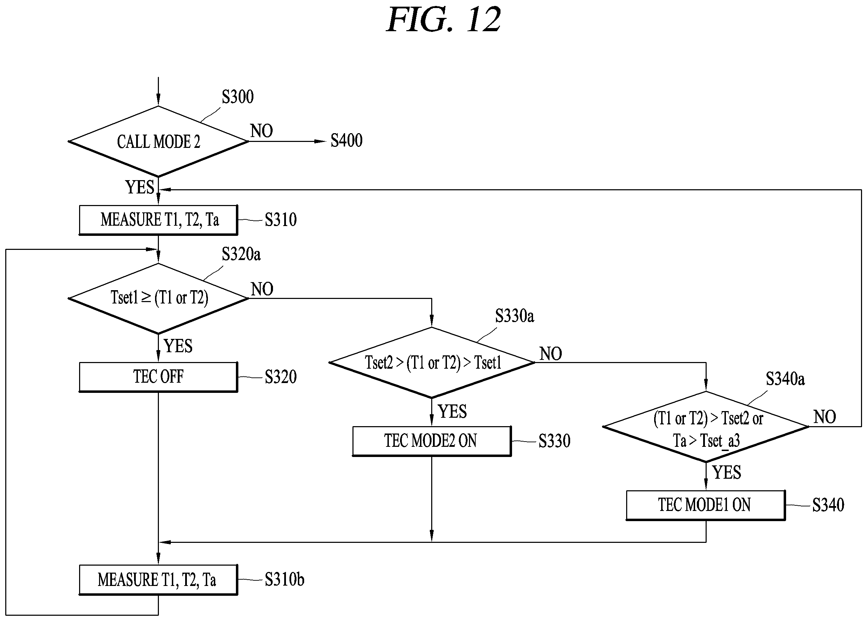

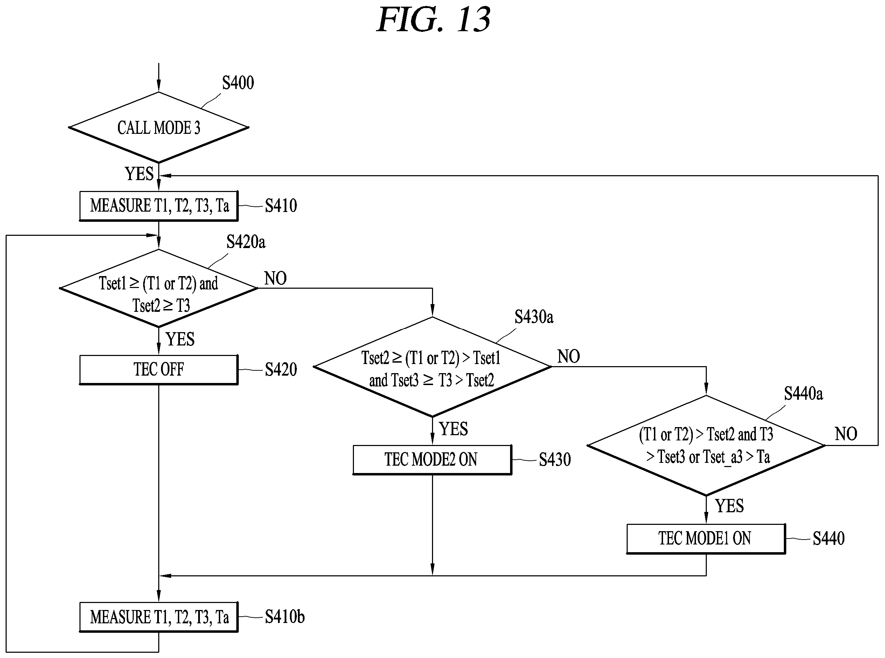

As described above, the telematics module mounted in the vehicle according to the present disclosure may be configured to operate in any one of the plurality of operating modes on the basis of temperatures of a plurality of components and the internal temperature of the telematics module. In this regard, FIGS. 11 to 13 are flowcharts illustrating methods of controlling the telematics module according to the first to third operating modes, respectively. FIG. 11 is the flowchart illustrating the method of controlling the telematics module that operates in the first operating mode, which is the emergency call mode. FIG. 12 is the flowchart illustrating the method of controlling the telematics module that operates in the second operating mode, which is the remote start mode. FIG. 13 is the flowchart illustrating the method of controlling the telematics module that operates in the third operating mode, which is the trip mode.

With reference to FIGS. 4 to 13, the control method that is performed by the NAD module 1300 of the telematics module mounted in the vehicle according to the present disclosure, and the telematics module 1000, performing the control method, are described in detail. The NAD module 1300 may execute the first operating mode according to the operating mode (S200). The NAD module 1300 may execute the second operating mode according to the operating mode (S300). The NAD module 1300 may execute the third operating mode according to the operating mode (S400). In each operating mode, the first temperature T1 of the memory 1310, the second temperature T2 of the RF transceiver 1320, the third temperature T3 of the electronic component 1410 of the V2X module 1400, and the internal temperature Ta of the telematics module 1000 may be measured (S210, S310, and S410).

In response to the booting signal, in each operating mode, the first heat dissipation mode in which the heat dissipation module 1500 is driven at the first voltage value may be executed. In response to the call order, in each operating mode, the second heat dissipation mode in which the heat dissipation module 1500 is driven at the second voltage value lower than the first voltage value may be executed.

The first operating mode is an e-call mode, and a condition for executing the first operating mode is the occurrence of an emergency event. The first operating mode is a mode in which the telematics module 1000 may maintain normal operation without failure for 300 seconds under an environment where the internal temperature Ta thereof reaches 105 degrees. In the first operating mode, the first temperature T1 of the memory 1310 may be compared with the first and second threshold temperatures Tset1 and Tset2 (S220a, S230a, and S240a), and, as a result, a heat dissipation operation may be stopped (S220), or the first heat dissipation mode or the second heat dissipation mode may be executed (S230 or S240).

The memory 1310 may operate for approximately 5 minutes even when the heat dissipation module 1500 does not operate at a temperature of 85 degrees, which is lower by 20 degrees than the specified temperature of 105 degrees for the memory 1310 configured as an MCP LPDDR 4 memory. Accordingly, the first threshold temperature Tset1 may be set to 85 degrees. The memory 1310 may operate for approximately 5 minutes despite temperature differences occurring, depending on the actual vehicle situation, even when the heat dissipation module 1500 does not operate. Thus, the condition for executing the first operating mode, which is an e-call mode, may be satisfied.

The second threshold temperature Tset2 may be set to 95 degrees for component operability and temperature reliability to secure a margin of 10 degrees or more below the specified temperature of 105 degrees for the memory 1310 configured as the MCP LPDDR4 memory. In the first operating mode, which is the e-call mode, a third threshold temperature Tset_a3 of the internal temperature Ta of the telematics module 1300 may be set to 105 degrees. In the first operating model, the NAD module 1300 may measure the first temperature T1 of the memory 1310 and the internal temperature Ta of the telematics module 1300 (S210).

When the first temperature T1 of the memory 1310 measured in the first operating mode is equal to or lower than the first threshold temperature Tset1 (S220a), the NAD module 1300 may control the heat dissipation module 1500 in such a manner that the heat dissipation operation thereof is stopped (S220). When the first temperature T1 of the memory 1310 is higher than the first threshold temperature Tset1 and is equal to or lower than the second threshold temperature Tset2 (S230a), the NAD module 1300 may control the heat dissipation module 1500 in such a manner that the heat dissipation module 1500 operates in the second heat dissipation mode (S230). The NAD module 1300 may drive the heat dissipation module 1500 at the second voltage value (e.g., 7 V) and a second current value (e.g., 1.0 A) in such a manner that the heat dissipation module 1500 operates in the second heat dissipation mode (S230). When the first temperature T1 of the memory 1310 is higher than the second threshold temperature Tset2 or the internal temperature Ta of the telematics module 1300 is higher than the third threshold temperature Tset_a3 (S240a), the NAD module 1300 may control the heat dissipation module 1500 in such a manner that the heat dissipation module 1500 operates in the first heat dissipation mode (S240). The NAD module 1300 may drive the heat dissipation module 1500 at the first voltage value (e.g., 10 V) and the first current value (e.g., 1.3 A) in such a manner that the heat dissipation module 1500 operates in the first heat dissipation mode (S240).

Subsequently, in each heat dissipation mode, the NAD module 1300 may re-measure the first temperature T1 of memory 1310 and the internal temperature Ta of the telematics module 1300 (S210b). Subsequently, the NAD module 1300 may repeat the steps S220a, S230a, and S240a of comparing the first temperature T1 of the memory 1310 with the first and second threshold temperatures Tset1 and Tset2.

The second operating mode is the remote start mode and is a mode in which the telematics module 1000 may maintain normal operation without failure for 60 seconds under the environment where the internal temperature Ta thereof reaches 105 degrees. In the second operating mode, the first temperature T1 of the memory 1310 or the second temperature T2 of the RF transceiver 1320 may be compared with the first and second threshold temperatures Tset1 and Tset2 (S220a, S230a, and S240a), and, as a result, the heat dissipation operation may be stopped (S320), or the first heat dissipation mode or the second heat dissipation mode may be executed (S330 or S340). In the second operating mode, the NAD module 1300 may measure the first temperature T1 of the memory 1310, the second temperature T2 of the RF transceiver 1320, and the internal temperature Ta of the telematics module 1300 (S310).

When the first temperature T1 of the memory 1310 or the second temperature T2 of the RF transceiver 1320, the first temperature T1 or the second temperature T2 being measured in the second operating mode, is equal to or lower than the first threshold temperature Tset1 (S320a), the NAD module 1300 may control the heat dissipation module 1500 in such a manner that the heat dissipation operation thereof is stopped (S320). When the first temperature T1 of the memory 1310 or the second temperature T2 of the RF transceiver 1320 is higher than the first threshold temperature Tset1 and is equal to or lower than the second threshold temperature Tset2 (S330a), the NAD module 1300 may control the heat dissipation module 1500 in such a manner that the heat dissipation module 1500 operates in the second heat dissipation mode (S330). The NAD module 1300 may drive the heat dissipation module 1500 at the second voltage value (e.g., 7 V) and the second current value (e.g., 1.0 A) in such a manner that the heat dissipation module 1500 operates in the second heat dissipation mode (S330).

When the first temperature T1 of the memory 1310 or the second temperature T2 of the RF transceiver 1320 is higher than the second threshold temperature Tset2, or the internal temperature Ta of the telematics module 1300 is higher than the third threshold temperature Tset_a3 (S340a), the NAD module 1300 may control the heat dissipation module 1500 in such a manner that the heat dissipation module 1500 operates in the first heat dissipation mode (S340). The NAD module 1300 may drive the heat dissipation module 1500 at the first voltage value (e.g., 10 V) and the first current value (e.g., 1.3 A) in such a manner that the heat dissipation module 1500 operates in the first heat dissipation mode (S340).

Subsequently, in each heat dissipation mode, the NAD module 1300 may re-measure the first temperature T1 of memory 1310, the second temperature T2 of the RF transceiver 1320, and the internal temperature Ta of the telematics module 1300 (S310b). Subsequently, the NAD module 1300 may repeat the steps S320a, S330a, and S340a of comparing the first temperature T1 of the memory 1310 or the second temperature T2 of the RF transceiver 1320 with the first and second threshold temperatures Tset1 and Tset2.

The third operating mode is the trip mode and is a mode in which the telematics module 1000 may maintain normal operation without failure for 1500 seconds under an environment where the internal temperature Ta thereof decreases from 105 degrees to 75 degrees. In the third operating mode, the first temperature T1 of the memory 1310 or the second temperature T2 of the RF transceiver 1320 may be compared with the first and second threshold temperatures Tset1 and Tset2, and the third temperature T3 of the electronic component 1410 may be compared with the third threshold temperature Tset3 (S220a, S230a, and S240a). As a result, the heat dissipation operation may be stopped (S320), or the first heat dissipation mode or the second heat dissipation mode may be executed (S330 or S340). In the third operating mode, the NAD module 1300 may measure the first temperature T1 of the memory 1310, the second temperature T2 of the RF transceiver 1320, the third temperature T3 of the electronic component 1410 of the V2X module 1400, and the internal temperature Ta of the telematics module 1300 (S410).

The NAD module 1300 determines whether the first temperature T1 of the memory 1310 or the second temperature T2 of the RF transceiver 1320, each of which is measured in the third operating mode, is equal to or lower than the first threshold temperature Tset1 and whether the third temperature T3 of the electronic component 1410 of the V2X module 1400 is equal to or lower than the second threshold temperature Tset2 (S420a). Accordingly, the NAD module 1300 may control the heat dissipation module 1500 in such a manner that the heat dissipation operation thereof is stopped (S420). The NAD module 1300 determines whether the first temperature T1 of the memory 1310 or the second temperature T2 of the RF transceiver 1320 is higher than the first threshold temperature Tset1 and equal to or lower than the second threshold temperature Tset2 and whether the third temperature T3 of the electronic component 1410 is higher than the second threshold temperature Tset2 and equal to or lower than the third threshold temperature Tset3 (S430a). Accordingly, the NAD module 1300 may control the heat dissipation module 1500 in such a manner that the heat dissipation module 1500 operates in the second heat dissipation mode (S430). The NAD module 1300 may drive the heat dissipation module 1500 at the second voltage value (e.g., 7 V) and the second current value (e.g., 1.0 A) in such a manner that the heat dissipation module 1500 operates in the second heat dissipation mode (S430).

The NAD module 1300 determines whether the first temperature T1 of the memory 1310 or the second temperature T2 of the RF transceiver 1320 is higher than the second threshold temperature Tset2 and equal to or lower than the third threshold temperature Tset3, and whether the third temperature T3 of the electronic component 1410 is higher than the third threshold temperature Tset3 (S440a). In addition, the NAD module 1300 determines whether the internal temperature Ta of the telematics module 1000 is higher than the third threshold temperature Tset_a3. Accordingly, the NAD module 1300 may control the heat dissipation module 1500 in such a manner that the heat dissipation module 1500 operates in the first heat dissipation mode (S440). The NAD module 1300 may drive the heat dissipation module 1500 at the first voltage value (e.g., 10 V) and the first current value (e.g., 1.3 A) in such a manner that the heat dissipation module 1500 operates in the first heat dissipation mode (S440).

Subsequently, in each heat dissipation mode, the NAD module 1300 may re-measure the first temperature T1 of the memory 1310, the second temperature T2 of the RF transceiver 1320, the third temperature T3 of the electronic component 1410 of the V2X module 1400, and the internal temperature Ta of the telematics module 1300. Subsequently, the steps S420a, S430a, and S440a of comparing the first temperature T1 of the memory 1310 or the second temperature T2 of the RF transceiver 1320 with the first or second threshold temperatures Tset1 or Tset2 and comparing the third temperature T3 of the electronic component 1410 with the third threshold temperature Tset3 may be repeated.

As described above, the telematics module mounted in the vehicle according to the present disclosure may be configured to operate in any one of the plurality of operating modes on the basis of the temperatures of the plurality of components and the internal temperature of the telematics module. The temperatures of a plurality of electronic components of the telematics module and the internal temperature of the telematics module may not be measured or may be measured within an abnormal temperature range that deviates from a normal operating range. Accordingly, when the temperatures of a plurality of electronic components of the telematics module and the internal temperature of the telematics module are not measured or are measured within the abnormal temperature range that deviates from the normal operating range, there is a need to control the driving of the heat dissipation module using another method.

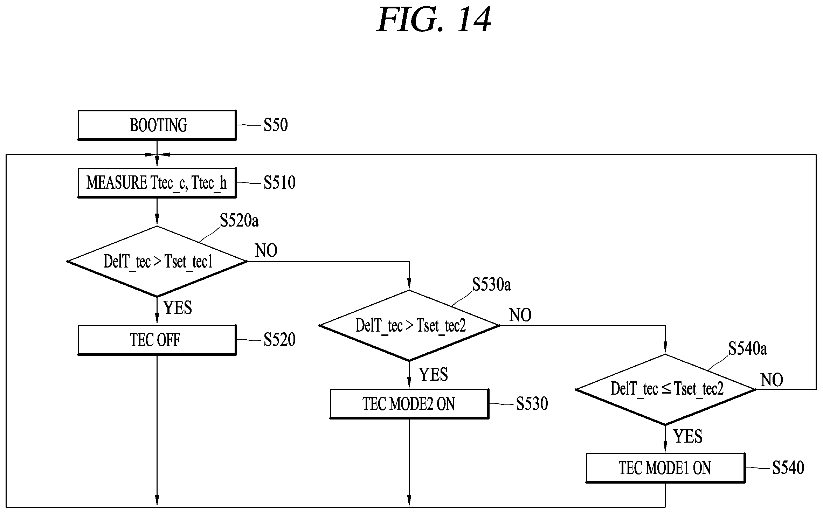

In this regard, FIG. 14 is a flowchart illustrating a method of controlling the driving of the heat dissipation module based on a temperature difference at both ends of the heat dissipation module. With reference to FIGS. 4 to 14, the method of controlling the driving of the heat dissipation module based on the temperature difference at both ends of the heat dissipation module according to the present disclosure will be described below.

In a case where the first temperature T1 of the memory 1310, the second temperature T2 of the RF transceiver 1320, the third temperature T3 of the electronic component 1410 of the V2X module 1400, or the internal temperature Ta of the telematics module 1300 is not measured or where an abnormal temperature is measured, the driving of the heat dissipation module 1500 may be controlled based on the temperature difference at both ends thereof. At this point, examples of the abnormal temperature include a temperature representing a case where the temperature difference at both ends of the heat dissipation module 1500 is 30 degrees, where a temperature measurement is not conducted, or where the measured temperature deviates from a normal temperature measurement range.

In this regard, the NAD module 1300 may execute the booting mode based on the booting signal (S50). The NAD module 1300 may measure a first temperature Ttec_c of a first surface S1 of the heat dissipation module 1500 and a second temperature Ttec_h of a second surface S2 thereof (S510). The first surface S1 of the heat dissipation module 1500 may be coupled to the NAD module 1300 and may be formed to have a lower temperature than the second surface S2. The second surface S2 of the heat dissipation module 1500 may be coupled to the lower cover 1020 and may be formed to have a higher temperature than the first surface S1. The first surface S1 and the second surface S2 of the heat dissipation module 1500 may be referred to as the cool side and the hot side, respectively.

In this regard, a step S10 of applying electric power to the NAD module 1300 and a step S20 of measuring the first temperature T1 of the memory 1320 and the internal temperature Ta may be performed. In addition, the NAD module 1300 may perform a step S30 of determining whether the internal temperature Ta or the first temperature T1 of the memory 1320 is equal to or higher than the first threshold temperature Tset_a or Tset1. In addition, in a case where the internal temperature Ta is higher than the first threshold temperature Tset_a or where the first temperature T1 of the memory 1320 is higher than the first threshold temperature Tset1, a step S40 of controlling the heat dissipation module 1500 in such a manner as to operate in the first heat dissipation mode. Subsequently, a step S20b of re-measuring the first temperature T1 of the memory 1320 and the internal temperature Ta of the NAD module 1300 may be performed. Subsequently, a step S30b of determining whether the internal temperature Ta and the first temperature T1 of the memory 1320 are lower than the first threshold temperature Tset_a and Tset1, respectively, may be performed. Subsequently, the booting mode based on the booting signal may be executed (S50).

The NAD module 1300 may determine whether a temperature difference DelT_tec between the first surface S1 and the second surface S2 of the heat dissipation module 1500 is higher than a first threshold temperature difference Tset_tec1 in the booting mode based on the booting signal (S520a). When the temperature difference DelT_tec is higher than the first threshold temperature difference Tset_tec1, the NAD module 1300 may control the heat dissipation module 1500 in such a manner that the heat dissipation operation is stopped (S520). The NAD module 1300 may determine whether the temperature difference (DelT_tec) between the first surface S1 and the second surface S2 of the heat dissipation module 1500 is equal to or lower than the first threshold temperature difference Tset_tec1 and higher than a second threshold temperature difference Tset_tec2. In this regard, the first threshold temperature difference Tset_tec1 may be set to 40 degrees, but without being limited thereto, may vary according to the application. The second threshold temperature difference Tset_tec2 may be set to 30 degrees, but without being limited thereto, may vary according to the application.

When the temperature difference DelT_tec is higher than the second threshold temperature difference Tset_tec2, the NAD module 1300 may drive the heat dissipation module 1500 at the second voltage value in such a manner as to operate in the second heat dissipation mode (S530). The NAD module 1300 may determine whether the temperature difference DelT_tec between the first surface S1 and the second surface S2 of the heat dissipation module 1500 is equal to or lower than the second threshold temperature difference Tset_tec2 (S540a). When the temperature difference DelT_tec is equal to or lower than the second threshold temperature difference Tset_tec2, the NAD module 1300 may drive the heat dissipation module 1500 at the first voltage value in such a manner as to operate in the first heat dissipation mode (S540).

In this regard, the NAD module 1300 may determine whether, in the booting mode, the first temperature T1 of the memory 1310, the second temperature T2 of the RF transceiver 1320, and the third temperature T3 of the electronic component 1410 of the V2X module 1400 are not measured or are abnormal. The NAD module 1300 may determine that the first temperature T1, the second temperature T2, and the third temperature T3 are not measured or are abnormal, and may determine whether the temperature difference DelT_tec between the first surface S1 and the second surface S2 of the heat dissipation module 1500 is higher than the first threshold temperature difference Tset_tec1. Accordingly, the NAD module 1300 may control the heat dissipation module 1500 in such a manner that the heat dissipation operation thereof is stopped (S520).

The NAD module 1300 may determine that the first temperature T1, the second temperature T2, and the third temperature T3 are not measured or are abnormal, and may determine whether the temperature difference DelT_tec is higher than the second threshold temperature difference Tset_tec2. Accordingly, the NAD module 1300 may drive the heat dissipation module 1500 at the second voltage value in such a manner as to operate in the second heat dissipation mode. The NAD module 1300 may determine that the first temperature T1, the second temperature T2, and the third temperature T3 are not measured or are abnormal, and may determine whether the temperature difference DelT_tec is equal to or lower than the second threshold temperature difference Tset_tec2. Accordingly, the NAD module 1300 may drive the heat dissipation module 1500 at the first voltage value in such a manner as to operate in the first heat dissipation mode.

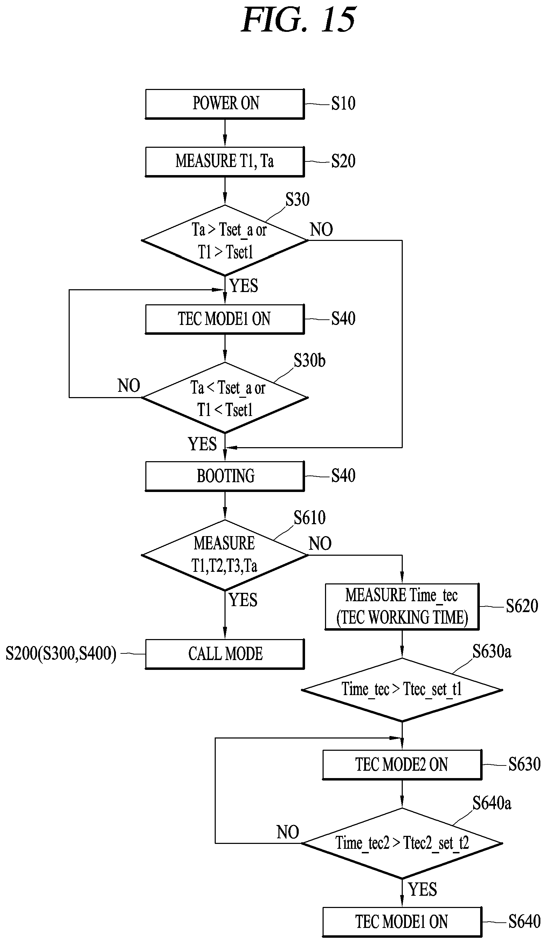

The telematics module according to the present disclosure may control the driving of the heat dissipation module based on the driving time of the heat dissipation module. FIG. 15 is a flowchart illustrating a method of controlling the driving of the heat dissipation module based on the driving time of the heat dissipation module. With reference to FIGS. 4 to 15, the method for controlling the driving of the heat dissipation module based on the driving time of the heat dissipation module according to the present disclosure.

In a case where the first temperature T1 of the memory 1310, the second temperature T2 of the RF transceiver 1320, the third temperature T3 of the electronic component 1410 of the V2X module 1400, or the internal temperature Ta of the telematics module 1300 is not measured or where an abnormal temperature is measured, the driving of the heat dissipation may be controlled based on the driving time of the heat dissipation module 1500. At this point, examples of the abnormal temperature include a temperature representing a case where the temperature of the heat dissipation module 1500 is not measured or deviates from the normal temperature measurement range.

In this regard, the step S10 of applying electric power to the NAD module 1300 and the step S20 of measuring the first temperature T1 of the memory 1320 and the internal temperature Ta of the NAD module 1300 may be performed. In addition, the NAD module 1300 may perform the step S30 of determining whether the internal temperature Ta or the first temperature T1 of the memory 1320 is equal to or higher than the first threshold temperature Tset_a or Tset1. In addition, in the case where the internal temperature Ta is higher than the first threshold temperature Tset_a or where the first temperature T1 of the memory 1320 is higher than the first threshold temperature Tset1, the step S40 of controlling the heat dissipation module 1500 in such a manner as to operate in the first heat dissipation mode. Subsequently, a step S30b of determining whether the internal temperature Ta and the first temperature T1 of the memory 1320 are lower than the first threshold temperature Tset_a and Tset1, respectively, may be performed. Subsequently, the booting mode based on the booting signal may be executed (S50).

When the driving time of the heat dissipation module 1500 is longer than a first threshold driving time Ttec_set_t1 in the booting mode based on the booting signal, the NAD module 1300 may drive the heat dissipation module 1500 at the second voltage value in such a manner as to operate in the second heat dissipation mode. When the driving time of the heat dissipation module 1500 is longer than a second threshold driving time Ttec_set_t2 in the booting mode, the NAD module 1300 may drive the heat dissipation module 1500 at the first voltage value in such a manner as to operate in the first heat dissipation mode. The second threshold driving Ttec_set_t2 may be set to be longer than the first threshold driving time Ttec_set_t1.

In this regard, the NAD module 1300 may determine whether, in the booting mode, the first temperature T1 of the memory 1310, the second temperature T2 of the RF transceiver 1320, the third temperature T3 of the electronic component 1410 of the V2X module 1400, and the internal temperature Ta of the telematics module 1300 are not measured or are abnormal (S610). When the first temperature T1, the second temperature T2, the third temperature T3, and the internal temperature Ta are measured to fall within a normal range, any one of the first to third operating modes may be executed (S220, S300, and S400).

The NAD module 1300 may measure the driving time Time_tec of the heat dissipation module 1500 in the booting mode based on the booting signal (S620). The NAD module 1300 may determine whether the driving time Time_tec of the heat dissipation module 1500 is longer than the first threshold driving time Ttec_set_t1. When the driving time Time_tec of the heat dissipation module 1500 is longer than the first threshold driving time Ttec_set_t1, the NAD module 1300 may drive the heat dissipation module 1500 at the second voltage value in such a manner as to operate in the second heat dissipation mode (S630).

The NAD module 1300 may determine whether the driving time Time_tec of the heat dissipation module 1500 is longer than the second threshold driving time Ttec_set_t2. When the driving time of the heat dissipation module 1500 is longer than the second threshold driving time Ttec_set_t2, the NAD module 1300 may drive the heat dissipation module 1500 at the first voltage value in such a manner as to operate in the first heat dissipation mode (S640).

When it is determined that the first temperature T1, the second temperature T2, and the third temperature T3 are not measured or are abnormal, and when the driving time Time_tec of the heat dissipation module 1500 is longer than the first threshold driving time Ttec_set_t1 in the booting mode, the NAD module 1300 may operate in the second heat dissipation mode (S630). The NAD module 1300 may drive the heat dissipation module 1500 at the second voltage value in such a manner as to operate in the second heat dissipation mode (S630). When it is determined that the first temperature T1, the second temperature T2, and the third temperature T3 are not measured or are abnormal, and when the driving time Time_tec of the heat dissipation module 1500 is longer than the second threshold driving time Ttec_set_t2 in the booting mode, the NAD module 1300 may operate in the first heat dissipation mode (S640). The NAD module 1300 may drive the heat dissipation module 1500 at the first voltage value in such a manner as to operate in the second heat dissipation mode (S640).

The telematics modules mounted in the vehicle and the method of controlling the telematics module have been described above. The technical effects of the telematics module mounted in the vehicle and the method of controlling the telematics module are described as follows.

According to the present disclosure, a priority is assigned to each communication mode, and a voltage for driving a heat dissipation structure is variably controlled according to the priority. To perform these functions, an antenna module, including a plurality of communication modules and the heat dissipation structure, can be provided in the vehicle.

According to the present disclosure, an optimal heat dissipation structure and a method of controlling heat dissipation can be implemented by considering a layout structure of electronic components arranged on different substrates corresponding to protrusion surfaces, respectively, of the lower cover.

According to the present disclosure, a method of controlling heat dissipation in a variable heat dissipation mode can be provided by driving a heat dissipation module at a driving voltage that varies according to the temperatures of electronic components arranged on a substrate.

According to the present disclosure, a method of controlling heat dissipation in a variable heat dissipation mode can be provided by driving the heat dissipation module at a driving voltage that varies according to different operating modes in the vehicle.

According to the present disclosure, a driving algorithm for the heat dissipation structure is changed according to each operating situation by applying the heat dissipation structure to a communication module and components within the telematics module. This change can achieve optimal heat dissipation, thereby ensuring the lifespans, operations, and temperature reliabilities of modules and components.

A further range of applications of the present disclosure will become apparent from the detailed description set forth above. However, it will be apparent to a person of ordinary skill in the art that various alterations and modifications to the present disclosure may be readily made without departing from the spirit and scope of the technical idea of the present disclosure. The detailed descriptions of specific embodiments, such as preferred embodiments of the disclosure, should be understood as illustrative examples only.

Therefore, the detailed description should not be interpreted in a limited manner in all respects, and should be considered as serving the purpose of illustration. The scope of the present disclosure should be determined by the proper interpretation of the following claims. All equivalent modifications to the embodiments of the present disclosure fall within the scope of the present disclosure.

## Claims

1. A telematics module for mounting in a vehicle, the telematics module comprising:
a lower cover that includes at least one protrusion surface protruding in the shape of an enclosure from a bottom surface coupled to a frame of the vehicle, the frame being formed of a metal material;
an upper cover coupled to the lower cover;
a PCB arranged in a space between the protrusion surface of the lower cover and the upper cover;
an NAD module, arranged in a first region of the PCB, the first region corresponding to the protrusion surface, that includes a modem, a memory, and an RF transceiver; and
a heat dissipation module, arranged between the NAD module and the protrusion surface, that operates according to a driving voltage and transfers heat generated in the NAD module to the protrusion surface and the frame,
wherein the NAD module assigns a priority to each communication mode and variably controls the driving voltage of the heat dissipation module according to the priority.

2. The telematics module of claim 1, wherein the protrusion surface includes a first protrusion surface corresponding to a first region of the PCB and a second protrusion surface corresponding to a second region of the PCB, the telematics module further comprising:
a V2X module arranged in the second region of the PCB, the second region corresponding to the second protrusion surface,
wherein the NAD module is arranged in the first region of the PCB, the first region corresponding to the first protrusion surface.

3. The telematics module of claim 2, wherein a plurality of integrated circuits, including the memory and the RF transceiver of the NAD module and an electronic component of the V2X module, have different reference temperatures for driving a TEC.

4. The telematics module of claim 3, wherein, in a case where the plurality of integrated circuits are driven simultaneously, the NAD module drives the heat dissipation module based on an integrated circuit having a low reference temperature for heat dissipation, among the plurality of integrated circuits.

5. The telematics module of claim 3, wherein the NAD module drives the heat dissipation module at a first voltage value in response to a booting signal and drives the heat dissipation module by a change to a second voltage value different from the first voltage value in response to a call order.

6. The telematics module of claim 5, wherein, in a case where a call is connected at the second voltage value in response to the call order, the NAD module drives the heat dissipation module by a change to a third voltage value lower than the second voltage value.

7. The telematics module of claim 2, wherein the heat dissipation module comprises:
a first heat dissipation module arranged in a first sub-region of the NAD module in which the modem and the memory adjacent to the modem are arranged, and
a second heat dissipation module arranged in a second sub-region of the NAD module in which the RF transceiver is arranged,
wherein, when the temperature of heat generated in the NAD module is equal to or higher than a first threshold temperature, the NAD module controls the first heat dissipation module and the second heat dissipation module in such a manner that the first heat dissipation module and the second heat dissipation module are driven simultaneously, and
wherein, when the temperature of the heat generated in the NAD module is lower than a second threshold temperature, the NAD module controls the first heat dissipation module and the second heat dissipation module in such a manner that the first heat dissipation module is driven and that the second heat dissipation module is not driven.

8. The telematics module of claim 5, wherein, in response to the booting signal and an operating mode, the NAD module controls the heat dissipation module in such a manner as to execute one of the following: a first operating mode, a second operating mode, or a third operating mode, among a plurality of operating modes,
wherein, in response to the booting signal, in each operating mode, a first heat dissipation mode in which the heat dissipation module is driven at the first voltage value is executed,
wherein, in response to the call order, in each operating mode, a second heat dissipation mode in which the heat dissipation module is driven at the second voltage value lower than the first voltage value is executed, and
wherein the first operating mode is an emergency call mode, the second operating mode is a remote start mode, and the third operating mode is a trip mode.

9. The telematics module of claim 8, wherein, when an internal temperature of the telematics module is higher than a first threshold temperature or a first temperature of the memory is higher than the first threshold temperature, the NAD module controls the heat dissipation module in such a manner that the heat dissipation module operates in the first heat dissipation mode in which the heat dissipation module operates at a maximum heat dissipation capacity, and
wherein, in the first heat dissipation mode, the first voltage value is applied to the heat dissipation module.

10. The telematics module of claim 9, wherein, when the first temperature of the memory, the first temperature being measured in the first operating mode, is equal to or lower than the first threshold temperature, the NAD module controls the heat dissipation module in such a manner that a heat dissipation operation thereof is stopped, and
wherein, when the first temperature of the memory is higher than the first threshold temperature and equal to or lower than a second threshold temperature, the NAD module drives the heat dissipation module at the second voltage value in such a manner that the heat dissipation module operates in the second heat dissipation mode.

11. The telematics module of claim 10, wherein, when the first temperature of the memory is higher than the second threshold temperature or when the internal temperature of the telematics module is higher than a third threshold temperature higher than the second threshold temperature, the NAD module drives the heat dissipation module at the first voltage value higher than the second voltage value in such a manner that the heat dissipation module operates in the first heat dissipation mode.

12. The telematics module of claim 11, wherein, when the first temperature of the memory or a second temperature of the RF transceiver, measured in the second operating mode, is equal to or lower than the first threshold temperature, the NAD module controls the heat dissipation module in such a manner that the heat dissipation operation thereof is stopped,
wherein, when the first temperature or the second temperature is higher than the first threshold temperature and equal to or lower than the second threshold temperature, the NAD module drives the heat dissipation module at the second voltage value in such a manner that the heat dissipation module operates in the second heat dissipation mode, and
wherein, when the first temperature or the second temperature is higher than the second threshold temperature or when the internal temperature is higher than the third threshold temperature, the NAD module drives the heat dissipation module at the first voltage value in such a manner that the heat dissipation module operates in the first heat dissipation mode.

13. The telematics module of claim 12, wherein, when the first temperature of the memory or the second temperature of the RF transceiver, the first temperature or the second temperature being measured in the third operating mode, is equal to or lower than the first threshold temperature and when a third temperature of the electronic component of the V2X module is equal to or lower than the second threshold temperature, the NAD module controls the heat dissipation module in such a manner that the heat dissipation operation thereof is stopped,
wherein, when the first temperature or the second temperature is higher than the first threshold temperature and equal to or lower than the second threshold temperature, and when the third temperature is higher than the second threshold temperature and equal to or lower than the third threshold temperature, the NAD module drives the heat dissipation module at the second voltage value in such a manner that the heat dissipation module operates in the second heat dissipation mode, and
wherein, when the first temperature or the second temperature is higher than the second threshold temperature, when the third temperature is higher than the third threshold temperature, and when the internal temperature is higher than the third threshold temperature, the NAD module drives the heat dissipation module at the first voltage value in such a manner that the heat dissipation module operates in the first heat dissipation mode.

14. The telematics module of claim 10, wherein, when a temperature difference between a first surface and a second surface of the heat dissipation module is higher than a first threshold temperature difference in a booting mode based on the booting signal, the NAD module controls the heat dissipation module in such a manner that the heat dissipation operation thereof is stopped,
wherein, when the temperature difference between the first surface and the second surface of the heat dissipation module is equal to or lower than the first threshold temperature difference, and is higher than a second threshold temperature difference, the NAD module drives the heat dissipation module at the second voltage value in such a manner that the heat dissipation module operates in the second heat dissipation mode, and
wherein, when the temperature difference between the first surface and the second surface of the heat dissipation module is equal to or lower than the second threshold temperature difference, the NAD module drives the heat dissipation module at the first voltage value in such a manner that the heat dissipation module operates in the first heat dissipation mode.

15. The telematics module of claim 14, wherein the NAD module determines whether, in the booting mode, the first temperature, a second temperature of the RF transceiver, and a third temperature of the electronic component of the V2X module are not measured or are abnormal,
wherein, when it is determined that the first temperature, the second temperature, and the third temperature are not measured or are abnormal, and when the temperature difference between the first surface and the second surface of the heat dissipation module is higher than the first threshold temperature difference, the NAD module controls the heat dissipation module in such a manner that the heat dissipation operation thereof is stopped,
wherein, when it is determined that the first temperature, the second temperature, and the third temperature are not measured or are abnormal, and when the temperature difference is higher than the second threshold temperature difference, the NAD module drives the heat dissipation module at the second voltage value in such a manner that the heat dissipation module operates in the second heat dissipation mode, and
wherein, when it is determined that the first temperature, the second temperature, and the third temperature are not measured or are abnormal, and when the temperature difference is equal to or lower than the second threshold temperature difference, the NAD module drives the heat dissipation module at the second voltage value in such a manner that the heat dissipation module operates in the first heat dissipation mode.

16. The telematics module of claim 10, wherein, when a driving time of the heat dissipation module is longer than a first threshold driving time in a booting mode based on the booting signal, the NAD module drives the heat dissipation module at the second voltage value in such a manner that the heat dissipation module operates in the second heat dissipation mode, and
wherein, when the driving time of the heat dissipation module is longer than a second threshold driving time longer than the first threshold driving time in the booting mode based on the booting signal, the NAD module drives the heat dissipation module at the first voltage value in such a manner that the heat dissipation module operates in a third heat dissipation mode.

17. The telematics module of claim 10, wherein the NAD module determines whether, in a booting mode based on the booting signal, the first temperature, a second temperature of the RF transceiver, and a third temperature of the electronic component of the V2X module are not measured or are abnormal,
wherein, when it is determined that the first temperature, the second temperature, and the third temperature are not measured or are abnormal, and when a driving time of the heat dissipation module is longer than a first threshold driving time in the booting mode, the NAD module drives the heat dissipation module at the second voltage value in such a manner that the heat dissipation module operates in the second heat dissipation mode, and
wherein, when it is determined that the first temperature, the second temperature, and the third temperature are not measured or are abnormal, and when the driving time of the heat dissipation module is longer than a second threshold driving time, the NAD module drives the heat dissipation module in such a manner that the heat dissipation module operates in a third heat dissipation mode.
